(19) Europäisches Patentamt
European Patent Office
Office européen des brevets

(11) Veröffentlichungsnummer: **0 244 749**
**B1**

(12) # EUROPÄISCHE PATENTSCHRIFT

(45) Veröffentlichungstag der Patentschrift: **16.05.90**

(51) Int. Cl.[5]: **G03F 7/038**, G03F 7/09

(21) Anmeldenummer: **87106213.9**

(22) Anmeldetag: **29.04.87**

(54) **Lichtempfindliches Gemisch und daraus hergestelltes lichtempfindliches Aufzeichnungsmaterial.**

(30) Priorität: **09.05.86 DE 3615612**

(43) Veröffentlichungstag der Anmeldung: **11.11.87 Patentblatt 87/46**

(45) Bekanntmachung des Hinweises auf die Patenterteilung: **16.05.90 Patentblatt 90/20**

(84) Benannte Vertragsstaaten: **DE FR GB**

(56) Entgegenhaltungen:
**DE-A- 2 053 364**
**DE-A- 3 036 077**
**DE-B- 1 302 833**
**US-A- 3 453 237**

**RESEARCH DISCLOSURE, Band 177, Nr. 110, Juni 1973, Seiten 72-80, Industrial Opportunities Ltd, GB; "Phosphorous containing photocrosslinkable polymers"**
**PHOTOPOLYMERS: PRINCIPLES, PROCESSES & MATERIALS, REGIONAL TECHNICAL CONFERENCE, 24.-26. Oktober 1973, Seiten 10-19, Society of Plastic Engineers, Inc.; D.G. BORDEN: "Photocrosslinkable polyphosphonates having unusual resistance to acids"**

(73) Patentinhaber: **HOECHST AKTIENGESELLSCHAFT, Postfach 80 03 20, D-6230 Frankfurt am Main 80(DE)**

(72) Erfinder: **Pawlowski, Geort, Dr., Blücherstrasse 48a, D-6200 Wiesbaden(DE)**
Erfinder: **Kleiner, Hans-Jerg, Dr., Altkönigstrasse 11a, D-6242 Kronberg 2(DE)**
Erfinder: **Gerdau, Thomas, Dr., Taunusstrasse 1a, D-6239 Eppstein(DE)**

**EP 0 244 749 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein lichtempfindliches Gemisch, das als wesentliche Bestandteile eine polymere Verbindung mit seitenständigen, olefinisch ungesättigten Resten und eine lichtempfindliche Verbindung enthält und das in hervorragender Weise zur Herstellung gedruckter Schaltungen in der Resisttechnik, insbesondere aber von Flachdruckformen für den Offsetdruck geeignet ist.

Gemische dieser Gattung sind in der DE-A 20 53 364 beschrieben. Sie enthalten Umsetzungsprodukte aus Hydroxyl- oder Aminogruppen enthaltenden Polymeren und ungesättigten Sulfonylisocyanaten sowie einen Initiator und gegebenenfalls weitere polymerisierbare Verbindungen.

Umsetzungsprodukte der gleichen Art in Kombination mit Diazoniumsalz-Polykondensaten oder niedermolekularen Aziden sind in der DE-A 30 36 077 beschrieben.

Nachteilig an diesen Gemischen ist einerseits die aufwendige und kostspielige Herstellung der erforderlichen Alkenylsulfonylisocyanate. Weiterhin zeigen die daraus hergestellten Druckplatten eine unzureichende Farbannahme, so daß beim Andruckprozeß und nach längerem Stillstand ein unvertretbar hoher Makulaturanfall entsteht. Insbesondere Gemische entsprechend der DE-A 20 53 364, in denen ausschließlich ein Photoinitiator und das beschriebene lichthärtbare Polymere vorliegen, weisen eine nur sehr geringe Lichtempfindlichkeit und eine schlechte Abriebbeständigkeit auf, so daß keine auflagenstarken Flachdruckformen mit diesen Materialien herstellbar sind.

Aus der DE-A 20 53 363 sind Gemische bekannt, die als Bindemittel Umsetzungsprodukte aus einem Hydroxyl- oder Aminogruppen enthaltenden Polymeren und mindestens einem gesättigten Alkyl-, Alkoxy-, Aryl- oder Aryloxysulfonylisocyanat enthalten. Das Bindemittel wird hier in Kombination mit Diazoniumsalz-Kondensationsprodukten oder photopolymerisierbaren Gemischen zu lichtempfindlichen Schichten verarbeitet. Die dabei erhaltenen Gemische lassen sich allerdings nur dann wäßrigalkalisch entwickeln, wenn die eingesetzten Bindemittel hohe Säurezahlen aufweisen, wodurch die Abriebbeständigkeit und auch die Druckeigenschaften der gehärteten Schicht nachteilig beeinflußt werden.

Aufgabe der vorliegenden Erfindung war es daher, ein lichtempfindliches Gemisch vorzuschlagen, das die bereits bestehenden Vorzüge der aus Sulfonylisocyanaten dargestellten photopolymerisierbaren Verbindungen aufweist, andererseits aber lichtempfindliche Schichten mit besserer Abriebbeständigkeit nach dem Belichten und Druckplatten mit besserer Farbannahme liefert und das aus leicht zugänglichen Ausgangsstoffen hergestellt werden kann.

Erfindungsgemäß wird ein lichtempfindliches Gemisch vorgeschlagen, das als wesentliche Bestandteile eine polymere Verbindung mit seitenständigen olefinisch ungesättigten Resten und eine lichtempfindliche Verbindung enthält.

Das erfindungsgemäße Gemisch ist dadurch gekennzeichnet, daß die polymere Verbindung ein Umsetzungsprodukt einer olefinisch ungesättigten Verbindung der allgemeinen Formel I

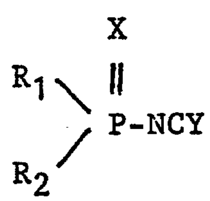 ,   (I)

worin

X und Y gleich oder verschieden sind und Sauerstoff oder Schwefel bedeuten,
$R_1$ ein olefinisch ungesättigter aliphatischer Rest mit 2 bis 8 C-Atomen und
$R_2$ ein gesättigter aliphatischer Rest mit 1 bis 8 C-Atomen oder ein Arylrest mit 6 bis 10 C-Atomen

ist, mit einem aktiven Wasserstoff enthaltenden Polymeren ist.

Die in dem erfindungsgemäßen Gemisch enthaltenen ungesättigten polymeren Verbindungen weisen als funktionelle Gruppen seitenständige, olefinisch ungesättigte (Thio)phosphinylurethan- oder -thiourethan- bzw. -harnstoff- oder -thioharnstoffgruppen auf. Diese Verbindungen entstehen durch Umsetzung von olefinisch ungesättigten Verbindungen der Formel I mit aktiven Wasserstoff enthaltenden Polymeren, z. B. mit Hydroxyl- oder Aminogruppen enthaltenden Polymeren.

Ist $R_1$ ein aliphatischer bzw. cycloaliphatischer Rest, so enthält er im allgemeinen eine oder zwei olefinische Doppelbindungen. Beispiele sind Vinyl-, Propenyl-, Allyl-, 1-Buten-4-yl-, 4-Chlor-butadienyl-, Cyclohexen-1-yl-, 3,5-Dimethyl-cyclohexen-1-yl- und 3-Vinyl-hexylreste. Insbesondere sind aliphatische Reste mit 2 bis 6, vorzugsweise mit 2 bis 3 C-Atomen zu nennen. Bevorzugte Beispiele sind Vinyl-, Allyl-, Methallyl- oder Crotylreste. Als Substituenten kommen Halogenatome, vorzugsweise Chlor in Frage.

$R_2$ kann vorzugsweise ein Alkylrest mit 1 bis 4, insbesondere 1 oder 2 C-Atomen oder ein substituierter Phenylrest sein. Als Substituenten kommen Halogenatome, insbesondere Chlor, Alkylreste oder Alkoxyreste mit 1 bis 4 C-Atomen in Betracht. Die aromatischen Reste $R_2$ können 1 bis 3, vorzugsweise 1

oder 2 Substituenten enthalten oder unsubstituiert sein.

Als bevorzugte ungesättigte (Thio)phosphinsäureiso(thio)cyanate werden genannt:
Allylmethylphosphinsäureisocyanat,
Allylmethylthiophosphinsäureisocyanat,
Allylmethylphosphinsäureisothiocyanat,
Allylmethylthiophosphinsäureisothiocyanat,
Crotylmethylphosphinsäureisocyanat,
β-Methallylmethylphosphinsäureisocyanat,
β-Methallylmethylphosphinsäureisothiocyanat,
Methylvinylphosphinsäureisocyanat,
Methylvinylthiophosphinsäureisocyanat,
Methylvinylphosphinsäureisothiocyanat,
Methylvinylthiophosphinsäureisothiocyanat
Ethylvinylphosphinsäureisocyanat,
Butylvinylphosphinsäureisocyanat,
Phenylvinylphosphinsäureisocyanat,
Phenylvinylthiophosphinsäureisocyanat,
Phenylvinylphosphinsäureisothiocyanat,
Phenylvinylthiophosphinsäureisothiocyanat.

Die genannten (Thio)phosphinsäurederivate lassen sich aus den entsprechenden (Thio)phosphinsäurechloriden der allgemeinen Formel II

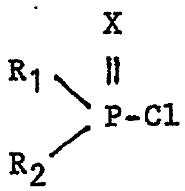

(II)

worin $R_1$, $R_2$ und X die oben angegebenen Bedeutungen haben, durch Umsetzung mit anorganischen Cyanaten bzw. Thiocyanaten herstellen.

Die Herstellung dieser Zwischenprodukte ist auch in der gleichzeitig eingereichten Patentanmeldung P (86/K021) beschrieben.

Die zur Umsetzung mit diesen Verbindungen befähigten, aktiven Wasserstoff enthaltenden Polymeren sind bevorzugt Hydroxyl- oder Aminogruppen aufweisende Polymere. Unter ihnen sind solche, die Hydroxylgruppen tragen, gegenüber solchen mit Aminogruppen bevorzugt, da die Urethangruppen enthaltenden, lichtempfindlichen Polymeren wesentlich besser in wäßrig-alkalischen Entwicklerlösungen löslich sind als solche, die Harnstoffgruppen aufweisen. Darüber hinaus sind die Umsetzungsprodukte mit Harnstoffgruppen häufig spröder und schlechter verarbeitbar.

Die gute Löslichkeit der (Thio)urethan- bzw (Thio)harnstoffgruppen aufweisenden Polymeren in wäßrig alkalischen Lösungen resultiert aus dem sauren Charakter der am Stickstoff gebundenen Wasserstoffatome infolge der Aktivierung durch die benachbarten Carbonyl- bzw. Phosphinsäuregruppen.

Als hydroxylgruppenhaltige Ausgangspolymere können beispielsweise Vinyl- oder Allylalkoholpolymerisate Verwendung finden. Bevorzugt eingesetzt werden Vinylalkoholpolymerisate, insbesondere teilacetalisierter oder teilveresterter Polyvinylalkohol. Unter diesen sind Polyvinylacetale bevorzugt, von denen insbesondere Polyvinylformale oder Polyvinylbutyrale mit mittleren Molekulargewichten zwischen 5.000 und 200.000 oder darüber, bevorzugt von 10.000 bis 100.000, und mit 5 bis 30 Gew.-% Vinylalkoholeinheiten Einsatz finden. Allylalkoholcopolymere können als Comonomereinheiten beispielsweise Styrol- oder substituierte Styroleinheiten enthalten, wobei der Allylalkoholanteil bevorzugt zwischen 10 und 40 Gew.-% beträgt. Darüber hinaus lassen sich Mischpolymerisate aus Vinyl- oder Allylalkohol mit Vinylestern, Vinylethern, Acrylaten, Methacrylaten oder (Meth)acrylnitril als Ausgangsmaterialien einsetzen.

Homopolymerisate oder Copolymerisate von Hydroxyalkyl(meth)acrylaten oder Glycerinmono(meth)acrylaten mit anderen bekannten (Meth)acrylaten, z. B. Methyl(meth)acrylat, Hexyl(meth)acrylat, (Meth)acrylnitril oder ähnlichen, lassen sich ebenfalls mit günstigen Ergebnissen als Hydroxylgruppen enthaltende Ausgangspolymere verwenden, wenn sie mehr als 10 Gew.-% Hydroxyalkyl(meth)acrylat- oder Glycerinmono(meth)acrylateinheiten enthalten.

Auch Epoxyharze, z. B. Kondensationsprodukte aus 2,2-Bis-(4-hydroxyphenyl)propan und Epichlorhydrin, oder Umsetzungsprodukte aus teilweise umgesetzten Glycidyl(meth)acrylaten lassen sich mit Vorteil verwenden, sofern diese Polymeren eine ausreichende Anzahl an freien reaktionsfähigen Hydroxylgruppen aufweisen und Molekulargewichte zwischen 2.000 und 200.000 besitzen.

Celluloseether und Celluloseester kommen ebenfalls in Betracht, sofern sie unumgesetzte Hydroxylgruppen aufweisen. Hier sind insbesondere die Partialester mit niedrigen aliphatischen Carbonsäuren zu nennen, wie beispielsweise Celluloseacetat. Geeignete Celluloseether sind beispielsweise gemischte Alkylhydroxyalkylether der Cellulosen. Bevorzugt sollten zwischen 0,3 und 2,3 freie Hydroxylgruppen pro Glucoseeinheit vorhanden sein.

Zu den kondensierbaren Polyestern gehören solche Verbindungen, die nicht vollständig verestert sind und aus Verzweigungen resultierende oder endständige Hydroxylgruppen enthalten, wobei der Grad der Verzweigung nicht zu hoch sein sollte.

Schließlich sind auch aminogruppenhaltige Verbindungen als Ausgangspolymere für die Umsetzung mit den olefinisch ungesättigten (Thio)phosphinsäureisocyanaten und -isothiocyanaten der allgemeinen Formel I verwendbar, wobei die daraus resultierenden Polymeren infolge ihrer häufig beobachtbaren Sprödigkeit jedoch nicht bevorzugt sind. Zudem lassen sie sich oft nicht rasch genug mit den wäßrig-alkalischen Entwicklerlösungen entwickeln oder die Polymeren haften zu stark am metallischen Substrat. Namentlich erwähnt seien jedoch Copolymere des N-Vinyl-N-methylamins sowie Polyamide, z. B. Polycaprolactam und Polyurethane, z. B. Umsetzungsprodukte von Diisocyanaten mit zwei- oder mehrwertigen Alkoholen, oder Polyamidimide.

Werden die erfindungsgemäß eingesetzten ungesättigten Polymeren im Offsetbereich eingesetzt, so sind die Umsetzungsprodukte mit Polyvinylacetalen besonders bevorzugt, während für Anwendungen in der Resisttechnik Copolymerisate des Hydroxyalkyl(meth)acrylats mit niedrigeren Molekulargewichten besonders geeignet sind.

Der Mengenanteil der ungesättigten Polymeren in dem erfindungsgemäßen Gemisch beträgt im allgemeinen 20 bis 95, vorzugsweise 40 bis 90 Gew.-%, bezogen auf die nichtflüchtigen Bestandteile.

Die Herstellung der ungesättigten Polymeren ist nicht kritisch, da die ungesättigten (Thio)phosphinsäureisocyanate und -isothiocyanate der allgemeinen Formel I überaus leicht mit Gruppierungen reagieren, die aktive Wasserstoffatome aufweisen, so daß bisweilen auf einen Zusatz von Katalysatoren oder eine Erhöhung der Reaktionstemperatur verzichtet werden kann.

Im allgemeinen wird zur Herstellung der ungesättigten Polymeren das aktiven Wasserstoff enthaltende Polymere in einem geeigneten, inerten Lösungsmittel, wie Dioxan, Tetrahydrofuran, Ethylenglykoldimethylether, Ethylenglykoldiacetat oder Butanon zu 2 bis 25 Gew.-% gelöst, und das entsprechende Isocyanat, bevorzugt gelöst im gleichen Lösungsmittel, wird bei Raumtemperatur zugetropft. Dabei läßt sich ein geringfügiges Ansteigen der Temperatur des Reaktionsgemischs beobachten.

Werden die Isothiocyanate der allgemeinen Formel I umgesetzt, so ist es sinnvoll, oben beschriebener Mischung einen Katalysator, beispielsweise Diazabicyclo[2,2,2]octan, zuzusetzen und bzw. oder die Mischung zu erwärmen.

Pro mol aktiven Wasserstoffs werden bevorzugt 0,4 bis 1,4 mol (Thio)phosphinsäureisocyanat und 0,4 bis 1,7 mol (Thio)phosphinsäureisothiocyanat zugegeben, da für einen quantitativen Umsatz aller reaktionsfähigen Gruppen des Ausgangspolymers ein Überschuß der Verbindungen der allgemeinen Formel I notwendig ist.

Die ungesättigten Polymeren können, gegebenenfalls nach Zerstörung überschüssigen Isocyanats oder Isothiocyanats durch Zugabe eines Alkohols, z. B. von Ethanol, in der Reaktionslösung weiterverarbeitet werden.

Zum Zweck der Charakterisierung oder für spezielle Anwendungen kann das Polymere durch Eintropfen in die 10-fache Menge eines Nichtlösemittels, bevorzugt in leicht angesäuertes Wasser, isoliert werden, wobei es als farbloses bis schwach gelbliches, amorphes, im allgemeinen jedoch gut filtrierbares Produkt anfällt. Das Produkt sollte vor der Anwendung in dem erfindungsgemäßen lichtempfindlichen Gemisch ausreichend getrocknet sein.

Als Photoinitiatoren im erfindungsgemäßen lichtempfindlichen Gemisch können zahlreiche Substanzen Verwendung finden. Beispiele sind Bezoine, Benzoinether, Mehrkernchinone, wie 2-Ethylanthrachinon, Acridinderivate, wie 9-Phenylacridin oder Benzacridine, Phenazinderivate, wie 9,10-Dimethylbenz[a]phenazin, Chinoxalin- oder Chinolinderivate, wie 2,3-Bis-(4-methoxylphenyl)chinoxalin oder 2-Styrylchinolin, Chinazolinverbindungen oder Acylphosphinoxidverbindungen. Photoinitiatoren dieser Art sind in den DE-C 20 27 467, 20 39 861 und der EP-B 11 786 beschrieben. Außerdem können beispielsweise Hydrazone, Mercaptoverbindungen, Pyrylium- oder Thiopyryliumsalze, synergistische Mischungen mit Ketonen oder Hydroxyketonen und Farbstoff-Redoxsysteme in Frage kommen. Besonders bevorzugt sind Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Vorzugsweise ist aber 2-(4'-Methoxystyryl)-4,6-bis-trichlormethyl-s-triazin zu nennen.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Die erfindungsgemäß eingesetzten ungesättigten Polymeren weisen in Kombination mit einem geeigneten Photoinitiator und ggf. einem polymerisierbaren Monomeren bereits sehr hohe Lichtempfindlichkeiten und ausreichende Härtung der belichteten Schichtbereiche auf. Sie ergeben ferner in Kombination mit den unterschiedlichsten negativ arbeitenden lichtempfindlichen Substanzen, wie beispielsweise Diazoniumsalz-Polykondensaten, Azidoderivaten oder p-Chinondiaziden, leicht und schleierfrei in wäßrig-alkalischen Medien entwickelbare Schichten, die sich durch höchste Abriebbeständigkeit und ausgezeichnete Wärmestandfestigkeit auszeichnen. Die derart erhaltenen Gemische sind daher ebenfalls für zahlreiche Anwendungsmöglichkeiten einsetzbar, wobei insbesondere wieder die Herstellung von lithographischen Platten und Photoresists erwähnt sein soll.

Es war überraschend, daß in den lichtempfindlichen Gemischen eine Kombination von ungesättigten Polymeren, Photoinitiatoren und anderen lichtempfindlichen Substanzen möglich war, ohne daß dadurch beispielsweise die Lagerfähigkeit des Gemischs nennenswert beeinträchtigt wird.

Darüber hinaus lassen sich die ungesättigten Polymeren in Kombination mit anderen lichtempfindlichen Substanzen als nicht lichtaktive Bindemittel verwenden, wobei auf den Zusatz eines Photoinitiators verzichtet werden kann. Derartige lichtempfindliche Gemische haben den Vorteil, daß eine thermische Härtung der entwickelten Schicht möglich ist, sofern dies erwünscht sein sollte.

In diesem Fall kann es vorteilhaft sein, der Schicht thermisch aktivierbare vernetzungsfähige Verbindungen, z. B. Epoxyverbindungen oder N-Methylol-amide, wie Hexamethylol- oder Hexamethoxymethylmelamin, zuzusetzen. Für diesen Zweck sind auch thermisch aktivierbare Polymerisationsinitiatoren, z. B. organische Peroxide, geeignet. Wenn die ungesättigten Polymeren, wie vorstehend beschrieben, als Bindemittel eingesetzt werden, können sie auch mit für den gleichen Zweck geeigneten gesättigten Polymeren kombiniert werden.

Polymerisierbare Verbindungen sind ebenfalls als Zusätze im erfindungsgemäßen Gemisch einsetzbar, insbesondere im Anwendungsbereich gedruckter Schaltungen.

Geeignete polymerisierbare Verbindungen sind aus den US-A 2 760 683 und 3 060 023 bekannt. Beispiele sind Acryl- oder Methacrylsäureester, wie Diglycerindiacrylat, Guajakolglycerinetheracrylat, Neopentylglykoldiacrylat, 2,2-Dimethylol-butan-3-ol-diacrylat, Pentaerythrittri- und -tetraacrylat sowie die entsprechenden Methacrylate. Geeignet sind ferner Acrylate oder Methacrylate, die Urethangruppen enthalten, sowie Acrylate bzw. Methacrylate hydroxylgruppenhaltiger Polyester. Schließlich sind auch Allyl- oder Vinylgruppen enthaltende Präpolymere geeignet, wobei insbesondere solche Monomeren oder Oligomeren bevorzugt werden, die mindestens zwei polymerisierbare Gruppen pro Molekül enthalten.

Die polymerisierbaren Verbindungen können im allgemeinen in einer Menge bis zu 50, vorzugsweise von 10 bis 35 Gew.-%, bezogen auf die nichtflüchtigen Bestandteile, in dem erfindungsgemäßen Gemisch enthalten sein.

Bei derartigen photopolymerisierbaren Mischungen ist es sinnvoll, die Initiatorkonzentration innerhalb des oben angegebenen Bereichs entsprechend dem ungesättigten Anteil der zugesetzten photopolymerisierbaren Monomeren oder Oligomeren zu erhöhen.

Als negativ arbeitende lichtempfindliche Substanzen lassen sich praktisch alle bekannten Verbindungen einsetzen, sofern sie mit der polymeren Matrix verträglich sind.

Beispielsweise sind Diazoniumsalz-Polykondensationsprodukte sehr gut geeignet, z. B. Kondensationsprodukte kondensationsfähiger aromatischer Diazoniumsalze mit Aldehyden. Als Beispiele seien Kondensationsprodukte von Diphenylamin-4-diazoniumsalzen mit Formaldehyd erwähnt. Vorteilhafterweise werden jedoch Mischkondensationsprodukte eingesetzt, welche außer den Diazoniumsalzeinheiten weitere, nicht lichtempfindliche Einheiten enthalten, welche sich von kondensationsfähigen Verbindungen ableiten. Derartige Kondensationsprodukte sind aus den DE-A 20 24 242, 20 24 243 und 20 24 244 bekannt. Allgemein sind jedoch alle Diazoniumsalz-Kondensate geeignet, welche in der DE-A 27 39 774 beschrieben sind.

Für gewisse Anwendungen sind als lichtempfindliche Verbindungen nieder- oder höhermolekulare Azidoderivate besonders geeignet, wobei niedermolekulare Azidoverbindungen mit mindestens zwei Azidogruppen pro Molekül bevorzugt werden. Als Beispiele seien 4,4'-Diazidostilbene, 4,4'-Diazidobenzophenone, 4,4'-Diazidobenzalacetophenone, 4,4'-Diazidobenzalacetone oder 4,4'-Diazidobenzalcyclohexanone genannt. Die Lichtempfindlichkeit derartiger Azidoverbindungen kann gegebenenfalls durch Verwendung geeigneter Sensibilisatoren, z. B. von 1,2-Benzanthrachinon, verstärkt werden. Weiterhin geeignet sind auch solche polyfunktionellen Azide, deren Eigenabsorption durch Konjugation mit Doppelbindungen im Molekül so verschoben ist, daß keine zusätzliche Sensibilisierung bei der Belichtung erforderlich ist. Weitere geeignete Azidoverbindungen sind aus der GB-A 790 131, der DE-C 950 618 und der US-A 2 848 328 bekannt.

Schließlich lassen sich auch niedermolekulare Diazoverbindungen, wie p-Chinondiazide oder p-Iminochinondiazide als lichtempfindliche Verbindungen verwenden. Derartige Mischungen sind aber wegen der geringen Lichtempfindlichkeit nicht bevorzugt.

Die Menge der lichtempfindlichen vernetzbaren Verbindung kann im allgemeinen 5 bis 60, vorzugsweise 10 bis 40 Gew.-%, bezogen auf die nichtflüchtigen Bestandteile des Gemischs, betragen.

Die erfindungsgemäßen Gemische lassen sich auf bekannte Weise entsprechend ihrem Anwendungszweck verarbeiten.

Dazu wird das ungesättigte Umsetzungsprodukt in einem geeigneten Lösungsmittel oder Lösungsmittelgemisch, aus dem die Beschichtung erfolgen soll, z. B. Ethylenglykolmonomethylether, Ethylenglykolmonoacetat, Dioxan, Tetrahydrofuran oder Butanon, gelöst, ggf. mit einem in dieser Mischung löslichen Photoinitiator versetzt oder ggf. durch den Zusatz weiterer lichtempfindlicher Substanzen sensibilisiert, die ebenfalls in Lösung gebracht werden.

Des weiteren können je nach Art der lichtempfindlichen Verbindung folgende Zusätze zur lichtempfindlichen Beschichtungslösung hinzugefügt werden

a) bei Sensibilisierung mit Diazoverbindungen, beispielsweise p-Chinondiaziden oder Diazoniumsalz-Kondensaten:

ein Farbstoff zur Sichtbarmachung der lichtempfindlichen Schicht auf dem Trägermaterial; eine Säure, bevorzugt Phosphorsäure, zur Stabilisierung des Diazoniumsalzes und ein Kontrastbildner, der eine Verstärkung der Farbänderung der Schicht bei Belichtung bewirkt,

b) bei Sensibilisierung mit Azidoverbindungen:

ein Farbstoff, der zur Sichtbarmachung der lichtempfindlichen Schicht und zur Empfindlichkeitserhöhung der lichtvernetzenden Verbindung im gewünschten Spektralbereich beiträgt,

c) bei Sensibilisierung mit photopolymerisierbaren Substanzen:

Photoinitiatoren, die bei Belichtung den Polymerisationsschritt auslösen, und Inhibitoren, welche eine thermisch ausgelöste Polymerisation unterdrücken.

Des weiteren können andere Zusätze, z. B. Weichmacher, Pigmente, weitere Harzkomponenten etc. dem lichtempfindlichen Gemisch zugefügt werden, sofern sie sich für den jeweiligen Anwendungszweck als geeignet erweisen. Derartige Zusätze, ihre Wirkungen und Verwendungsmöglichkeiten sind dem Fachmann bekannt.

Zur Weiterverarbeitung werden die erhaltenen Lösungen filtriert, um gegebenenfalls ungelöste Bestandteile zu entfernen, und in an sich bekannter Weise, z. B. durch Rakeln oder Schleudern, auf ein geeignetes Trägermaterial aufgetragen und getrocknet.

Als Trägermaterialien seien insbesondere Aluminium, welches mechanisch oder elektrochemisch aufgerauht und ggf. anodisiert und nachbehandelt worden ist, aluminiumkaschierte oder andersartig hydrophilierte Folien, kupferbedampfte Folien oder Mehrmetallfolien genannt.

Die Art des Auftrags hängt dabei in hohem Maß von der gewünschten Schichtdicke der lichtempfindlichen Schicht ab, wobei die bevorzugten Schichtdicken der getrockneten Schicht zwischen 0,5 und 200 µm liegen.

Nach ausreichender Trocknung können die Materialien in an sich bekannter Weise durch bildmäßige Belichtung mittels einer Negativ-Filmvorlage oder bei geeigneter Sensibilisierung mittels eines Laserstrahls und anschließende Entwicklung in ihre jeweilige Anwendungsform übergeführt werden.

Die Entwicklung erfolgt dabei bevorzugt mit wäßrigalkalischen Entwicklerlösungen, deren pH-Wert im Bereich zwischen etwa 8 und 13 liegt. Gegebenenfalls können die Entwickler Zusätze enthalten, die zu einem beschleunigten, praxisgerechten Entwicklungsvorgang beitragen. Als für diesen Zweck geeignete Zusätze seien insbesondere Tenside oder geringe Mengen eines wenig flüchtigen organischen Lösungsmittels, wie Benzylalkohol erwähnt. Die Zusammensetzung geeigneter Entwicklerlösungen für die erfindungsgemäßen lichtempfindlichen Schichten ist in erster Linie vom jeweiligen Anwendungszweck abhängig; sie sollten jedoch in der Regel mehr als 75 Gew.-% Wasser und weniger als 5 Gew.-% eines organischen Lösungsmittels enthalten.

Geeignete Entwicklerlösungen sind z. B. aus den DE-A 28 09 774, 31 00 259 oder 31 40 186 bekannt.

Die erfindungsgemäßen Gemische erlauben die Herstellung von Flachdruckformen mit sehr hoher Auflage. Diese zeigen eine günstige Farannahme unter Beibehaltung günstiger kopiertechnischer Eigenschaften. Für diesen Einsatzbereich sind als ungesättigte Polymere insbesondere Umsetzungsprodukte aus Polyvinylacetalen und Phosphinsäureisocyanaten der Formel I geeignet. Die aus lichtempfindlichen Gemischen mit diesen Polymeren erhaltenen Flachdruckplatten zeigen darüber hinaus eine leichte, schleierfreie Entwickelbarkeit mit wäßrig-alkalischen Entwicklerlösungen und eine sehr günstige Lagerungsbeständigkeit.

Mit den erfindungsgemäßen Gemischen sind weiterhin Photoresistschablonen ausgezeichneter Auflösung erhältlich. Für diesen Anwendungszweck sind jedoch als ungesättigte Polymere eher Umsetzungsprodukte von Copolymerisaten des Hydroxylkyl(meth)acrylats mit den Phosphinsäureisocyanaten der allgemeinen Formel I bevorzugt.

Die nachstehenden Beispiele sollen die Erfindung und ihre Anwendungsmöglichkeiten näher erläutern. Gewichtsteile und Volumenteile stehen im Verhältnis von g/cm³; Prozentangaben und Mengenverhältnisse sind in Gewichtseinheiten zu verstehen, wenn nichts anderes angegeben ist.

<u>Beispiel 1</u>

100 g (0,8 mol) Methyl-vinyl-phosphinsäurechlorid wurden in 100 ml Acetonitril gelöst. Unter lebhaftem Rühren wurden dazu portionsweise 52,2 g (0,8 mol) Natriumcyanat gegeben. Die Temperatur wurde durch Kühlung bei maximal ca. 40° C gehalten. Das Produkt wurde nach 24-stündigem Rühren abgesaugt und mit Acetonitril nachgewaschen. Das Filtrat wurde im Vakuum eingeengt. Der dabei entstandene Rückstand wurde bei einer Temperatur von 58 - 60° C und einem Druck von 52,6 Pa destilliert. Man erhielt 88 g (= 83,5 % d. Th.) Methyl-vinyl-phosphinsäureisocyanat.

| $C_4H_6NO_2P$ (131) | | | | |
|---|---|---|---|---|
| Ber.: | 36,6% C | 4,6% H | 10,7% N | 23,7% P |
| Gef.: | 35,9% C | 4,6% H | 10,3% N | 24,0% P |

20 Gt eines Polyvinylbutyrals mit einem Molekulargewicht von etwa 80.000, das 71 Gew.-% Vinylbutyral-, 2 Gew.-% Vinylacetat- und 27 Gew.-% Vinylalkohol-Einheiten enthält, wurden in 350 Gt Tetrahydrofuran klar gelöst. Zu dieser Lösung wurden 12 Gt Methyl-vinyl-phosphinsäureisocyanat in 50 Gt Tetrahydrofuran bei Raumtemperatur zugetropft. Die Mischung wurde 4 Stunden lang nachgerührt, mit 50 Gt Ethanol versetzt und anschließend in 5000 Gt heftig gerührtes destilliertes Wasser eingetropft. Es fiel ein faseriges, amorphes Produkt an, das abgesaugt und getrocknet wurde. Man erhielt 27 Gt eines weißen Polymeren, das eine Säurezahl von 75 und eine Zusammensetzung von C: 53,8 %, H: 8,3 %, N: 3,2 % und P: 6,6 % aufwies.

Es wurde eine Beschichtungslösung aus

3,2 Gt des vorstehend beschriebenen Umsetzungsprodukts,
0,32 Gt Viktoriareinblau FGA (C.I. Basic Blue 81) und
0,32 Gt 2-(4'-Methoxystyryl)-4,6-bis-trichlormethyl-s-triazin in
150,0 Gt Ethylenglykolmonomethylether

hergestellt.

Die filtrierte Lösung wurde auf eine 0,3 mm starke Aluminiumfolie, die durch Bürsten mit einer wäßrigen Schleifmittelsuspension aufgerauht und danach mit einer 0,1 %igen wäßrigen Lösung von Polyvinylphosphonsäure vorbehandelt worden war, aufgebracht und anschließend getrocknet.

Die so erhaltene Kopierschicht, die ein Trockenschichtgewicht von 0,76 g/m² aufwies, wurde unter einer Negativvorlage 35 Sekunden mit einer Metallhalogenid-Lampe von 5 kW Leistung belichtet.

Die belichtete Schicht, die eine deutliche Differenzierung der belichteten und unbelichteten Schichtbereiche aufwies, wurde mit einer Entwicklerlösung der folgenden Zusammensetzung

1 Gt Trinatriumphosphat × 12 $H_2O$ und
1 Gt Natriumoctylsulfat in
98 Gt destilliertem Wasser

mittels eines Plüschtampons behandelt, wobei die nichtbelichteten Schichtbereiche innerhalb von 15 Sekunden nach der Benetzung durch die Entwicklerflüssigkeit entfernt wurden. Anschließend wurde mit Wasser abgespült und getrocknet.

In der Kopie war die Stufe 4 eines Silberfilm-Halbtonstufenkeils mit einem Dichteumfang von 0,05 bis 3,05 und Dichteinkrementen von 0,15 voll abgebildet. Auch feinste Raster und Linien der Vorlage wurden klar wiedergegeben.

Die so behandelte Druckform wurde mit Schutzfarbe eingeschwärzt, die von den Bildstellen sofort angenommen wurde.

Beispiel 2

106 g (0,57 mol) Phenyl-vinyl-phosphinsäurechlorid wurden in 150 ml Acetonitril gelöst und mit 38 g (0,59 mol) Natriumcyanat bei einer Temperatur von 30° C gerührt. Nach 23 Stunden wurde das Produkt abgesaugt und mit Acetonitril gewaschen, das Filtrat eingeengt und der Rückstand bei einer Temperatur von 107-110° C und einem Druck von 33 Pa destilliert. Man erhielt 84 g (= 77 % d.Th) Phenyl-vinyl-phosphinsäureisocyanat.

| $C_9H_8NO_2P$ (193) | | | | |
|---|---|---|---|---|
| Ber.: | 56,0% C | 4,2% H | 7,3% N | 16,0% P |
| Gef.: | 54,9% C | 4,0% H | 7,1% N | 16,0% P |

20 Gt des in Beispiel 1 beschriebenen Polyvinylbutyrals wurden wie dort angegeben mit 14 Gt Phenyl-vinyl-phosphinsäureisocyanat umgesetzt. Man erhielt ein farbloses Produkt mit einer Säurezahl von 58 und einer Zusammensetzung von C: 59,8 %, H: 9,4 %, N: 1,8 % und P: 4,3 %.

Aus

3,2 Gt des vorstehend beschriebenen Umsetzungsprodukts,
0,32 Gt Viktoriareinblau FGA (C.I. Basic Blue 81) und
0,32 Gt 2-(4'-Styrylphenyl)-4,6-bis-trichlormethyl-s-triazin in
150 Gt Ethylenglykolmonomethylether

wurde eine Beschichtungslösung hergestellt und auf eine Aluminiumfolie, die in Salpetersäure elektrochemisch aufgerauht, dann anodisiert und mit Polyvinylphosphonsäure behandelt worden war, aufgebracht und zu einem Schichtgewicht von 0,8 $g/m^2$ getrocknet.

Die Belichtung und Entwicklung erfolgte ähnlich wie in Beispiel 1 angegeben. Auch in diesem Fall wurden eine gedeckte Stufe 4 im vorstehend beschriebenen Halbtonstufenkeil erhalten.

Die erhaltene Flachdruckform wurde in eine Bogenoffsetmaschine eingespannt und bis zu einer Auflage von 140.00 gedruckt. Nach dem Abbruch des Druckversuchs zeigte sich, daß die eingesetzte Platte noch einwandfrei war.

Beispiel 3

100 g (0,8 mol) Methyl-vinyl-phosphinsäurechlorid wurden in 160 ml Acetonitril gelöst. Unter lebhaftem Rühren wurden dazu portionsweise 61 g (0,8 mol) Ammoniumthiocyanat gegeben. Durch leichte Kühlung wurde die Temperatur bei maximal 30° C gehalten. Nach 3 Tagen Rühren wurde das Produkt abgesaugt und mit Acetonitril nachgewaschen. Das Filtrat wurde im Vakuum eingeengt. Der dabei entstandene Rückstand wurde bei einer Temperatur von 70° C und einem Druck von 6,7 Pa destilliert. Man erhielt 65 g (= 55,1 % d. Th.) Methyl-vinyl-phosphinsäureisothiocyanat.

| $C_4H_6NOPS$ (147) | | | | | |
|---|---|---|---|---|---|
| Ber.: | 32,6% C | 4,1% H | 9,5% N | 21,2% P | 21,8% S |
| Gef.: | 32,4% C | 4,1% H | 9,3% N | 21,2% P | 21,9% S |

20 Gt des in Beispiel 1 beschriebenen Polyvinylbutyrals wurden in 350 Gt Tetrahydrofuran gelöst. Zur klaren Lösung wurden 0,2 Gt Diazabicyclo[2,2,2]octan hinzugefügt. Anschließend wurden 12 Gt Methyl-vinyl-phosphinsäureisothiocyanat in 50 Gt Tetrahydrofuran zugetropft, wobei keine Temperaturerhöhung registriert wurde. Das Gemisch wurde auf Rückflußtemperatur gebracht und 5 Stunden bei dieser Temperatur belassen. In dieser Zeit färbte sich die klare Lösung gelb. Nach dem Erkalten wurde diese Lösung in 5.000 Gt Wasser eingetropft und das entstehende gelbe, faserige Produkt abgesaugt und isoliert. Es hatte eine Zusammensetzung von C: 57,8 %, H: 9,0 %, N: 1,4%, P: 3,7 % und S: 3,4 %.

Eine Beschichtungslösung wurde aus

3,2 Gt des vorstehend beschriebenen Umsetzungsprodukts,
0,1 Gt Kristallviolett (C.I. 42555),
0,1 Gt Phenylazodiphenylamin und
0,25 Gt 2-(4'-Ethoxynaphth-1-yl)-4,6-bis-trichlormethyl-s-triazin in
150,0 Gt Ethylenglykolmonomethylether

bereitet und entsprechend Beispiel 2 auf eine Aluminiumplatte aufgebracht. Das Trockenschichtgewicht betrug 0,78 $g/m^2$.

Die belichtete Schicht wurde mit einem Entwickler der Zusammensetzung

5 Gt Natriumlaurylsulfat und
3 Gt Natriummetasilikat × 5 $H_2O$ in
92 Gt destilliertem Wasser

wie im Beispiel 1 behandelt.

Das Testen der Flachdruckform in einer Bogenoffsetmaschine ergab viele Tausend einwandfreie Drucke.

Beispiel 4

20 Gt eines Polyvinylbutyrals mit einem Molekulargewicht über 80.000, das 77 bis 80 Gew.-% Vinylbutyral-, 2 Gew.-% Vinylacetat- und 18 bis 21 Gew.-% Vinylalkoholeinheiten enthielt, wurden entsprechend Beispiel 1 mit 16 Gt Methylvinylthiophosphinsäureisocyanat in Tetrahydrofuran umgesetzt. Das erhaltene Produkt war schwach gelblich gefärbt und hatte einen Phosphorgehalt von 6,7 % und einen Schwefelanteil von 6,1 %.

Entsprechend dem vorhergehenden Beispiel wurde eine Beschichtungslösung bereitet, in der als Photoinitiator 2-(4'-Trichlormethylbenzoylmethylen)-3-ethyl-benzothiazolin verwendet wurde.

Nach Filtration wurde die Lösung auf eine elektrochemisch aufgerauhte, anodisierte und mit Polyvinylphosphonsäure nachbehandelte Aluminiumfolie aufgetragen und zu einem Schichtgewicht von 1,05 $g/m^2$ getrocknet.

Anschließend wurde durch eine Vorlage 50 Sekunden belichtet und mit einem Entwickler nachstehender Zusammensetzung behandelt:

3,0 Gt Natriumoctylsulfat,
2,0 Gt Kaliumoxalat,
4,0 Gt Dinatriumhydrogenphosphat × 12 $H_2O$,
1,5 Gt Trinatriumphosphat × 12 $H_2O$ und
0,2 Gt Natriummetasilikat × 9 $H_2O$ in
89,3 Gt destilliertem Wasser.

Die unbelichteten Schichtbereiche ließen sich mittels eines in der Entwicklerlösung getränkten Plüschtampons leicht und schleierfrei entfernen. Die Vorlage war tadellos wiedergegeben.

Die Druckform wurde in eine Bogenoffsetmaschine eingespannt und lieferte mehr als 150.000 guter Drucke.

Beispiel 5

200 g (1,23 mol) Crotyl-methyl-phosphinsäureethylester wurden in 150 ml Dichlormethan gelöst, und unter Kühlung wurde bei einer Temperatur von 12-15° C innerhalb von 3,5 Stunden Phosgen eingeleitet. Es wurde noch eine Stunde bei 25° C nachgerührt und anschließend destilliert. Man erhielt 182 g (= 97 % d. Th.) Crotyl-methyl-phosphinsäurechlorid vom Siedepunkt 83-85° C (260 Pa.).

| $C_5H_{10}ClOP$ (153) | | | |
|---|---|---|---|
| Ber.: | 39,4% C | 6,6% H | 20,3% P |
| Gef.: | 39,9% C | 6,5% H | 20,1% P |

170 g (1,1 mol) Crotyl-methyl-phosphinsäurechlorid wurden in 300 ml Acetonitril gelöst und mit 73 g (1,1 mol) Natriumcyanat auf 55° C unter Rühren erwärmt. Nach 4,5 Stunden wurde das Produkt abgesaugt und mit Acetonitril gewaschen, das Filtrat eingeengt und der Rückstand bei einer Temperatur von 76-78° C und einem Druck von 27 Pa destilliert. Man erhielt 123 g (= 70 % d. Th.) Crotyl-methyl-phosphinsäure-isocyanat.

| $C_6H_{10}NO_2P$ (159) | | | | |
|---|---|---|---|---|
| Ber.: | 45,3% C | 6,3% H | 8,8% N | 19,5% P |
| Gef.: | 45,0% C | 6,2% H | 8,6% N | 19,4% P |

11,3 Gt des in Beispiel 1 beschriebenen Polyvinylbutyrals wurden in 160 Gt Tetrahydrofuran gelöst. Zu der klaren Lösung wurden 7,2 Gt Crotyl-methyl-phosphinsäureisocyanat in 25 Gt Tetrahydrofuran getropft und 4 Stunden bei Raumtemperatur belassen. Das anschließend in Wasser ausgefällte und isolierte Produkt hatte eine Säurezahl von 87.

Eine Beschichtungslösung wurde aus

48,5 Gt des oben beschriebenen Umsetzungsprodukts,
24,1 Gt eines Diazoniumsalz-Polykondensationsprodukts, hergestellt aus 1 mol 3-Methoxydiphenylamin-4-diazoniumsulfat und 1 mol 4,4'-Bis(methoxymethyl)diphenylether in 85 %iger Phosphorsäure und isoliert als Mesitylensulfonat,
2,4 Gt Phosphorsäure (85%),
1,8 Gt Viktoriareinblau FGA (C.I. Basic Blue 81) und
0,9 Gt Phenylazodiphenylamin in
1700,0 Gt Ethylenglykolmonomethylether und
518,0 Gt Tetrahydrofuran

hergestellt.

Die filtrierte Lösung wurde auf eine Aluminiumfolie, welche entsprechend Beispiel 2 vorbehandelt worden war, zu einem Trockenschichtgewicht von 1,0 g/m² aufgetragen.

Die Kopierschicht wurde 35 Sekunden unter einer Negativvorlage belichtet.

Zur Entwicklung wurde eine Lösung, bestehend aus

5,0 Gt Natriumlaurylsulfat,
1,5 Gt Natriummetasilikat × 5 $H_2O$ und
1,0 Gt Trinatriumphosphat × 12 $H_2O$ in
92,5 Gt entsalztem Wasser

verwendet. In der erhaltenen Kopie war die Stufe 5 des Halbtonstufenkeils noch voll abgebildet.

Nach Einspannen der Druckform in eine Bogenoffsetmaschine erhielt man mehr als 130.000 qualitativ einwandfreier Drucke.

Beispiel 6

Der Beschichtungslösung des Beispiels 5 wurden zusätzlich

2,6 Gt 2-(4'-Styrylphenyl)-4,6-bis-trichlormethyl-s-triazin

zugegeben.

Die Kopie entsprach bei gleichem Schichtgewicht in ihrer Lichtempfindlichkeit der des vorstehenden Beispiels.

Bei einem Druckversuch wurde allerdings eine Auflage von mehr als 170.000 qualitativ guter Drucke erhalten.

Beispiel 7

Eine Beschichtungslösung wurde bereitet aus

27,2 Gt einer 8,4 %igen Lösung des in Beispiel 1 beschriebenen Umsetzungsprodukts in Tetrahydrofuran,
0,5 Gt des in Beispiel 5 beschriebenen Diazoniumsalz-Polykondensationsprodukts,
0,1 Gt Phosphorsäure (85 %),
0,03 Gt Phenylazodiphenylamin,
0,06 Gt 2-(4'-Methoxystyryl)-4,6-bis-trichlormethyl-s-triazin und
0,03 Gt eines blauen Azofarbstoffs, erhalten durch Kupplung von 2,4-Dinitro-6-chlorbenzoldiazoniumsalz an 2-Methoxy-5-acetylamino-N-cyanoethyl-N-hydroxyethylanilin in
150,0 Gt Ethylenglykolmonomethylether.

Die filtrierte Lösung wurde auf eine in Salzsäure elektrolytisch aufgerauhte, dann anodisierte und nachbehandelte Aluminiumfolie aufgetragen und zu einem Schichtgewicht von 1,1 g/m² getrocknet.

Die Schicht wurde durch eine Negativvorlage 35 Sekunden lang belichtet, wobei man eine gedeckte Stufe 5 erhielt. Die Entwicklung erfolgte wie in Beispiel 5 beschrieben. Nach dem Einspannen der Druckform in eine Bogenoffsetmaschine konnte beobachtet werden, daß die Druckform die angebotene Farbe sehr rasch annahm, so daß nur wenig Makulatur entstand. Der Druckversuch wurde nach 150.000 Drucken abgebrochen, wobei die eingesetzte Flachdruckform keinerlei Abrieberscheinungen aufwies.

Beispiel 8

Die in den Beispielen 5 und 6 beschriebenen Lösungen wurden auf je fünf elektrochemisch aufgerauhte, anodisierte und mit Polyvinylphosphonsäure behandelte Aluminiumplatten aufgetragen. Die 10 Muster wiesen jeweils ein Schichtgewicht zwischen 1,03 und 1,11 g/m² auf. Die erhaltenen Platten wurden in einem auf 100° C vorgeheizten Trockenschrank paarweise (jeweils ein Muster nach Beispiel 5 und 6) eine, zwei bis zu fünf Stunden gelagert. Die abgekühlten Platten wurden 35 Sekunden unter einer Testvorlage belichtet und mit dem Entwickler aus Beispiel 5 verarbeitet.

Die eine oder zwei Stunden gelagerten Druckplatten nach beiden Beispielen zeigten gegenüber einer normal verarbeiteten Kopie keine Veränderung. Die Schicht des Beispiels 5 entsprach nach drei Stunden Lagerung ebenfalls weitgehend der Vergleichskopie, während sich die Schicht des Beispiels 6 leicht verzögert entwickeln ließ und eine Verlängerung des Halbtonstufenkeils um etwa 2 Stufen zeigte. Diesen Effekt zeigte auch die 4 Stunden gelagerte Schicht des Beispiels 5, während die entsprechende Schicht des Beispiels 6 nur noch unter Fladenbildung entwickelt werden konnte. Sie zeigte auch Neigung, beim Einspannen in die Druckmaschine an den Nichtbildstellen Farbe anzunehmen. Dies gilt auch, aber in deutlich stärkerem Maß, für die fünf Stunden gelagerten Platten.

Insgesamt läßt sich aus dem vorliegenden Beispiel ablesen, daß die recht gute Lagerstabilität der Schicht des Beispiels 5 durch den Zusatz eines Photoinitiators (Beispiel 6) überraschend wenig beeinflußt wird.

Beispiel 9

Ein Terpolymerisat, welches aus 50 Gew.-% Hydroxyethylmethacrylat, 20 Gew.-% Methylmethacrylat und 30 Gew.-% Hexylmethacrylat bestand, wurde mit einem Überschuß von Methylvinylphosphinsäureisocyanat (Herstellung vgl. Beispiel 1) versetzt, so daß alle Hydroxylgruppen in ungesättigte Phosphinylurethangruppen übergeführt wurden. Das erhaltene Polymer hatte ein mittleres Molekulargewicht von etwa 32.000.

Aus

6,5 Gt des oben beschriebenen Umsetzungsprodukts,
5,6 Gt eines technischen Gemischs aus Pentaerythrittri- und -tetramethacrylat,
0,3 Gt 2-(4'-Methoxystyryl)-4,6-bis-trichlormethyl-s-triazin und

0,03 Gt des in Beispiel 7 beschriebenen Azofarbstoffs in
25,0 Gt Butanon,
2,0 Gt Ethanol und
1,0 Gt Butylacetat

wurde eine Lösung bereitet, die auf eine biaxial verstreckte und thermofixierte Polyethylenterephthalatfolie der Stärke 25 µm so aufgeschleudert wurde, daß nach dem Trocknen bei 100° C ein Schichtgewicht von 35 g/m² erhalten wurde.

Die derart hergestellte Trockenresistfolie wurde mit einer Laminiervorrichtung bei 120° C auf eine mit 35 µm starker Kupferfolie kaschierte Phenoplast-Schichtstoffplatte laminiert und etwa 25 Sekunden unter einem handelsüblichen Belichtungsgerät belichtet. Als Vorlage diente eine Strichvorlage mit Linienbreiten und Abständen bis zu 80 µm.

Nach der Belichtung wurde die Polyesterfolie abgezogen und die erhaltene Schicht mit einer Entwicklerlösung der Zusammensetzung

3,0 Gt Natriummetasilikat × 9 $H_2O$ und
0,04 Gt nichtionogenes Netzmittel (Kokosfettalkoholpolyoxyethylenether mit ca. 8 Oxyethyleneinheiten) in
96,96 Gt entsalztem Wasser

in einem Sprühentwicklungsgerät 90 Sekunden lang entwickelt. Anschließend wurde die Platte 30 Sekunden mit Leitungswasser gespült, 30 Sekunden mit einer 15 %igen Ammoniumperoxydisulfat-Lösung angeätzt und schließlich in den folgenden Elektrolytbädern galvanisiert:

1) 30 Minuten in einem Kupferelektrolyten der Fa. Schlötter, Geislingen/Steige, Typ "Glanzkupfer-Bad".
Stromdichte: 2,5 A/dm².
Metallaufbau: ca. 15 µm.

2) 10 Minuten in einem Nickelbad der Fa. Schlötter, Geislingen/Steige, Typ "Norma".
Stromdichte 4 A/dm².
Metallaufbau: 9 µm.

Die Platte zeigte keine Beschädigungen oder Unterwanderungen. Die Entschichtung erfolgte mit 5 %iger KOH-Lösung bei 50° C. Das freigelegte Kupfer wurde mit üblichen Ätzmedien weggeätzt.

Beispiel 10

140 g (0,86 mol) β-Methallyl-methyl-phosphinsäureethylester wurden in 120 ml Dichlormethan gelöst, und innerhalb von 3 Stunden wurde bei einer Temperatur von 15-20° C Phosgen eingeleitet. Es wurde noch 2 Stunden bei 25° C nachgerührt und anschließend destilliert. Man erhielt 127 g (= 97 % d. Th.) β-Methallyl-methyl-phosphinsäurechlorid vom Siedepunkt 66-68° C (27 Pa).

| $C_5H_{10}ClOP$ (153) | | | |
|---|---|---|---|
| Ber.: | 39,4% C | 6,6% H | 20,3% P |
| Gef.: | 39,8% C | 6,8% H | 20,6% P |

127 g (0,83 mol) β-Methallyl-methyl-phosphinsäurechlorid wurden in 200 ml Acetonitril gelöst und zusammen mit 54 g (0,83 mol) Natriumcyanat unter Rühren auf 50-55° C erwärmt. Nach 5 Stunden wurde das Produkt abgesaugt und mit Acetonitril gewaschen, das Filtrat eingeengt und bei einer Temperatur von 70-75° C und einem Druck von 13 Pa destilliert. Man erhielt 115 g (= 87 % d. Th.) β-Methallyl-methyl-phosphinsäureisocyanat.

| $C_6H_{10}NO_2P$ (159) | | | | |
|---|---|---|---|---|
| Ber.: | 45,3% C | 6,3% H | 8,8% N | 19,5% P |
| Gef.: | 45,2% C | 6,4% H | 8,6% N | 18,9% P |

20 Gt eines Epoxidharzes (Epikote 1007, Fa. Shell) wurden in 300 Gt Tetrahydrofuran gelöst. Zur klaren Lösung wurden 12 Gt β-Methallyl-methyl-phosphinsäureisocyanat in 30 Gt Tetrahydrofuran getropft und 4 Stunden bei Raumtemperatur belassen.

Eine Beschichtungslösung aus

22,6 Gt einer 8,84 %igen Lösung des vorstehend beschriebenen Umsetzungsproduktes in Tetrahydrofuran,
1,5 Gt Trimethylolpropantrimethacrylat,
0,8 Gt eines technischen Gemischs aus Pentaerythrittri- und -tetraacrylat,
0,2 Gt 2-(4'-Trichlormethyl-benzoylmethylen)-3-ethylbenzothiazolin und
0,01 Gt p-Methoxyphenol in
60,0 Gt Ethylenglykolmonomethylether

wurde auf eine elektrochemisch aufgerauhte, anodisierte und nachbehandelte Aluminiumfolie zu einer Stärke von 3,2 µm aufgetragen. Die getrocknete Schicht wurde mit Polyvinylalkohol (etwa 1 g/m²) überzogen und unter einer Negativvorlage bildmäßig belichtet.

Man erhielt eine hervorragend auflösende Druckform, die in einer Bogenoffsetmaschine eine sehr hohe Auflage erzielte.

Beispiel 11

Eine Beschichtungslösung wurde hergestellt aus

20,0 Gt des in Beispiel 2 beschriebenen Umsetzungsprodukts aus einem Polyvinylacetal und Phenylvinylphosphinsäureisocyanat (Herstellung vgl. Beispiel 2),
18,0 Gt 2,6-Bis-(4'-azidobenzal)cyclohexanon,
2,5 Gt Rhodamin 6 GDN extra (C.I. 45160) und
1,9 Gt 2-(4'-Styrylphenyl)-4,6-bis-trichlormethyl-s-triazin in
900,0 Gt Ethylenglykolmonomethylether und
450,0 Gt Tetrahydrofuran.

Diese Lösung wurde entsprechend Beispiel 2 auf eine Aluminiumplatte zu einem Trockenschichtgewicht von 0,9 g/m² aufgetragen.

Nach dem Belichten unter einer Negativvorlage wurde mit einem Entwickler der Zusammensetzung

5 Gt Triethanolammoniumlaurylsulfat,
1 Gt Natriummetalsilikat × 5 $H_2O$ und
1 Gt Trinatriumphosphat × 12 $H_2O$ in
93 Gt Wasser

entwickelt und konserviert.

Mit der in dieser Weise erhaltenen Druckform wurde an einer Bogenoffsetmaschine eine Auflage von mehr als 170.000 qualitativ einwandfreier Drucke erzielt.

Beispiel 12

Eine Beschichtungslösung wurde aus

53,5 Gt des in Beispiel 10 beschriebenen polymeren Umsetzungsprodukts als 8,8 %ige Lösung in Tetrahydrofuran,
4,4 Gt 4,4'-Diazidostilben-3,3'-disulfonsäure,
0,4 Gt Rhodamin 6 GDN extra,
0,3 Gt 2-Bezoylmethylen-1-methyl-β-naphthothiazolin und
0,2 Gt 2-Ethylanthrachinon in
200 Gt Ethylenglykolmonomethylether und
80 Gt eines technischen Gemischs aus Butanol/Butylacetat (15 : 85)

bereitet.

Die Lösung wurde auf den in Beispiel 2 beschriebenen Träger zu einem Trockenschichtgewicht von 0,8 g/m² aufgetragen.

Die Kopieschicht wurde 35 Sekunden unter einer Negativvorlage belichtet, wobei ein positives dunkelrotes Bild entstand.

Die Schicht wurde mit der Entwicklerlösung aus Beispiel 3 verarbeitet. In der Kopie war die Stufe 5 voll gedeckt.

Man erhielt eine Auflage von ca. 130.000 Bogen, wobei die Flachdruckform an den Bildstellen - auch nach längerem Stehen - sofort Farbe annahm.

Beispiel 13

Eine Beschichtungslösung wurde hergestellt aus

3,0 Gt des in Beispiel 1 beschriebenen polymeren Umsetzungsprodukts,
1,0 Gt des in Beispiel 5 beschriebenen Diazoniumsalz-Kondensationsprodukts,
0,2 Gt Viktoriareinblau FGA,
0,3 Gt eines technischen Gemischs aus Pentaerythrittri- und -tetraacrylat,
0,3 Gt 2-(4'-Methoxystyryl)-4,6-bis-trichlormethyl-s-triazin und
0,1 Gt Phosphorsäure (85 %) in
100 Gt Ethylenglykolmonomethylether und
80 Gt Tetrahydrofuran

und auf eine entsprechend Beispiel 2 behandelte Aluminiumfolie aufgetragen. Das Trockenschichtgewicht betrug 1,6 g/m$^2$.

Die erhaltene Kopierschicht wurde 30 Sekunden unter einer Negativvorlage belichtet, wobei man eine gedeckte Stufe 5 des Halbtonstufenkeils erhielt.

Als Entwickler fand eine Mischung aus

0,2 Gt Natriummetasilikat × 9 $H_2O$,
3,9 Gt Dinatriumhydrogenphosphat × 12 $H_2O$,
3,5 Gt Trinatriumphosphat × 12 $H_2O$,
1,5 Gt Kaliumtetraborat × 4 $H_2O$ und
2,9 Gt Natriumoctylsulfat in
88,0 Gt entsalztem Wasser

Verwendung.

Mit der entwickelten Druckform wurden in einer Bogenoffsetmaschine weit mehr als 250.000 Drucke erzielt.

Beispiele 14-17

Entsprechend dem Beispiel 1 wurden 20 Gt des dort beschriebenen Polyvinylbutyrals mit je 8 Gt nachstehender Phosphinsäureisocyanate umgesetzt:

Beispiel 14: Methylvinylphosphinsäureisocyanat
(Herstellung vgl. Beispiel 1)
Säurezahl: 54; Analyse: C: 55,8 %,
H: 8,3 %, N: 1,9 %, P: 3,9 %.

Beispiel 15: Allylmethylphosphinsäureisocyanat
Säurezahl: 46; Analyse: C: 58,3 %,
H: 9,1 %, N: 1,6%, P: 3,6 %.

Beispiel 16: Crotylmethylphosphinsäureisocyanat
(Herstellung vgl. Beispiel 5)
Säurezahl: 50; Analyse: C: 58,1 %,
H: 8,5 %, N: 2,0 %, P: 3,8 %

Beispiel 17: β-Methallylmethylphosphinsäureisocyanat
(Herstellung vgl. Beispiel 10)
Säurezahl: 42; Analyse: C: 57,7 %,
H: 9,0 %, N: 1,5 %, P: 3,7 %.

Herstellung von Allyl-methyl-phosphinsäureisocyanat :

166 g (1,2 mol) Allyl-methyl-phosphinsäurechlorid wurden in 300 ml Acetonitril gelöst und mit 78 g (1,2 mol) Natriumcyanat auf 50-55° C unter Rühren erwärmt. Nach 5,5 Stunden wurde das Produkt abgesaugt und mit Acetonitril gewaschen, das Filtrat eingeengt und der Rückstand bei einer Temperatur von 78-80° C und einem Druck von 25 Pa destilliert. Man erhielt 123 g (= 71 % d. Th.) Allyl-methyl-phosphinsäureisocyanat.

| $C_5H_8NO_2P$ (145) | | | | |
|---|---|---|---|---|
| Ber.: | 41,4% C | 5,6% H | 9,7% N | 21,4% P |
| Gef.: | 41,6% C | 5,7% H | 9,5% N | 21,0% P |

Aus diesen Polymeren wurden entsprechend Beispiel 1 Beschichtungslösungen bereitet und auf eine elektrochemisch aufgerauhte, anodisierte und mit Polyvinylphosphonsäure vorbehandelte Aluminumfolie aufgetragen und zu einem mittleren Trockenschichtgewicht von ca. 0,8 g/m² getrocknet.

Nach der Belichtung erfolgte mit der in Beispiel 1 angegebenen Entwicklerzusammensetzung die Freilegung der Nichtbildstellen.

Um eine praxisgerechte Differenzierung zwischen Bild- und Nichtbildstellen zu erreichen, mußte die Schicht des Beispiels 14 24 Sekunden, die das Beispiels 15 35 Sekunden und die der Beispiele 16 und 17 50 Sekunden belichtet werden.

Beispiel 18

Eine mit dünner Kupferfolie kaschierte Kunststoffplatte wurde nach der Reinigung der Kupferoberfläche mit einem Scheuermittel und anschließendem Abspülen mit Aceton mit einer Lösung folgender Zusammensetzung beschichtet:

13,0 Gt des in Beispiel 1 beschriebenen polymeren Umsetzungsprodukts,
11,0 Gt 4,4'-Bis-(β-acryloyloxyethoxy)-diphenylether,
0,4 Gt 2-(4'-Methoxystyryl)-4,6-bis-trichlormethyl-s-triazin und
0,1 Gt Kristallviolet in
150 Gt Butanon,
40 Gt Ethanol und
76 Gt Butylacetat.

Es wurde ein Schichtgewicht (trocken) von 3 g/m² eingestellt. Man belichtete durch ein Negativ, welches ein Schaltschema darstellte und entwickelte entsprechend Beispiel 9.

Durch Wegätzen des Kupfers an den freigelegten Stellen mit 40%iger wäßriger Eisen-III-chlorid-Lösung wurde eine gedruckte Schaltung erhalten.

Beispiele 19 und 20

Entsprechend Beispiel 1 wurden zwei Beschichtungslösungen unter Verwendung der Polymeren der Beispiele 14 und 16 bereitet und auf eine elektrochemisch vorbehandelte Aluminiumfolie aufgetragen. Das Schichtgewicht betrug in beiden Fällen etwa 1 g/m².

Nach Belichtung und Entwicklung wurden die erhaltenen Kopien konserviert und 5 Minuten auf 200° C erwärmt. Beide Druckformen erzielten in der Bogenoffsetmaschine hohe Auflagen qualitativ einwandfreier Drucke.

Beispiel 21

140 (0,86 mol) β-Methallyl-methyl-phosphinsäureethylester wurden in 120 ml Dichlormethan gelöst, und innerhalb von 3 Stunden wurde bei einer Temperatur von 15-20° C Phosgen eingeleitet. Es wurde noch 2 Stunden bei 25° C nachgerührt und anschließend destilliert. Man erhielt 127 g (= 97 % d.Th.) β-Methallyl-methyl-phosphinsäurechlorid vom Siedepunkt 66-68° C (27 Pa).

| $C_5H_{10}ClOP$ (153) | | | |
|---|---|---|---|
| Ber.: | 39,4% C | 6,6% H | 20,3% P |
| Gef.: | 39,8% C | 6,8% H | 20,6% P |

83 g (0,55 mol) β-Methallyl-methyl-phosphinsäurechlorid wurden in 200 ml Acetonitril mit 42 g (0,55 mol) Ammoniumthiocyanat unter leichter Kühlung versetzt und anschließend bei einer Temperature von ca. 30° C gerührt. Nach 3 Tagen wurden vom Niederschlag abgesaugt und dieser mit etwas Acetonitril gewaschen, das Filtrat eingeengt und destilliert. Man erhielt 72 g (= 75 % d. Th.) β-Methallyl-methyl-phosphinsäure-isothiocyanat vom Siedepunkt 98-100° C (66 Pa).

| | | | | | |
|---|---|---|---|---|---|
| $C_6H_{10}NOPS$ (175) | | | | | |
| Ber.: | 41,1% C | 5,8% H | 8,0% N | 17,7% P | 18,3% S |
| Gef.: | 41,0% C | 5,6% H | 8,6% N | 17,4% P | 18,0% S |

20 Gt des in Beispiel 1 beschriebenen Polyvinylbutyrals wurden in 300 Gt Tetrahydrofuran gelöst und mit 0,2 Gt Diazabicyclo[2,2,2]octan versetzt. 16 Gt β-Methallyl-methyl-phosphinsäure-isothiocyanat in 50 Gt Tetrahydrofuran wurden dazugetropft, und die Mischung wurde 6 Stunden am Rückfluß gehalten. Die gelbe Lösung wurde in 6000 Gt Wasser eingetropft, wobei 34 Gt eines gelben, faserigen Polymeren erhalten wurden, das 7,2 % Phosphor und 6,1 % Schwefel enthielt.

Eine Beschichtungslösung wurde bereitet aus

25 Gt des vorstehend beschriebenen Umsetzungsprodukts,
25 Gt des in Beispiel 5 beschriebenen Diazoniumsalz-Polykondensats,
2,5 Gt Phosphorsäure (85 %),
2,0 Gt Viktoriareinblau FGA und
0,8 Gt Phenylazodiphenylamin in
1600 Gt Ethylenglykolmonomethylether.

Nach Belichtung durch eine Negativvorlage wurde mit dem in Beispiel 13 verwendeten Entwickler rasch ein klar differenziertes Bild der Vorlage erhalten.

In der Druckmaschine wurde die Farbe schon während der ersten 6 Drucke vollständig angenommen. Es wurde eine Auflagenleistung von deutlich über 100.000 Drucken erzielt.

Beispiel 22

20 Gt eines Polyamids (Ultramid 1C(R), BASF) wurden ca. 12 Stunden in 200 Gt Phosphorsäure-tris-dimethylamid angequollen und anschließend unter heftigem Rühren innerhalb von 4 Stunden gelöst. Zu der klaren Lösung wurden bei 30° C 15 Gt Phenylvinylphosphinsäureisocyanat (Herstellung vgl. Beispiel 2) zugetropft. Die Mischung wurde 6 Stunden nachgerührt und anschließend in einer Mischung aus 10 % Ethanol und 90 % Wasser ausgefällt. Der Niederschlag wurde filtriert nachgewaschen und getrocknet.

Es wurde eine Beschichtungslösung aus

8,0 Gt des oben beschriebenen Umsetzungsprodukts,
7,5 Gt eines technischen Produktgemischs aus Pentaerythrittri- und -tetraacrylat,
0,5 Gt 2-(4'-Methoxystyryl)-4,6-bis-trichlormethyl-s-triazin,
1,3 Gt eines Kupferphthalocyanin-Pigments und
0,1 Gt 4-Methoxyphenol in
200,0 Gt Ethylenglykolmonomethylether und
150,0 Gt Dimethylformamid

bereitet.

Die Beschichtung erfolgte wie in Beispiel 10 beschrieben. Nach Belichtung und Entwicklung mit einem Entwicklergemisch aus

4 Gt Benzylalkohol,
3 Gt Natriumlaurylsulfat,
3 Gt Trinatriumphosphat und
1 Gt Natriumhydroxid in
89 Gt Wasser

wurde eine praxisgerechte Druckform erhalten, mit der man eine sehr hohe Auflagenleistung erzielte.

## Patentansprüche

1. Lichtempfindliches Gemisch, das als wesentliche Bestandteile eine polymere Verbindung mit seitenständigen olefinisch ungesättigten Resten und eine lichtempfindliche Verbindung enthält, dadurch gekennzeichnet, daß die polymere Verbindung ein Umsetzungsprodukt einer olefinisch ungesättigten Verbindung der allgemeinen Formel I

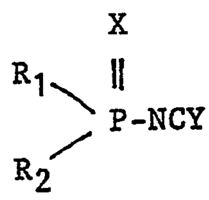

(I)

worin

X und Y gleich oder verschieden sind und Sauerstoff oder Schwefel bedeuten,
$R_1$ ein olefinisch ungesättigter aliphatischer Rest mit 2 bis 8 C-Atomen und
$R_2$ ein gesättigter aliphatischer Rest mit 1 bis 8 C-Atomen oder ein Arylrest mit 6 bis 10 C-Atomen

ist, mit einem aktiven Wasserstoff enthaltenden Polymeren ist.

2. Lichtempfindliches Gemisch nach Anspruch 1, dadurch gekennzeichnet, daß $R_1$ ein olefinisch ungesättigter aliphatischer Rest mit 2 bis 4 C-Atomen ist.

3. Lichtempfindliches Gemisch nach Anspruch 1 oder 2, dadurch gekennzeichnet, daß $R_2$ ein gesättigter aliphatischer Rest mit 1 bis 2 C-Atomen oder ein gegebenenfalls substituierter Phenylrest ist.

4. Lichtempfindliches Gemisch nach einem der Ansprüche 1 bis 3, dadurch gekennzeichnet, daß $R_1$ eine Vinylgruppe ist und X und Y Sauerstoffatome sind.

5. Lichtempfindliches Gemisch nach Anspruch 1, dadurch gekennzeichnet, daß das aktiven Wasserstoff enthaltende Polymere ein Hydroxyl- oder Aminogruppen enthaltendes Polymeres ist.

6. Lichtempfindliches Gemisch nach Anspruch 5, dadurch gekennzeichnet, daß das Hydroxyl- oder Aminogruppen enthaltende Polymere ein Vinylalkohol-, Allylalkohol-, Hydroxyalkylacrylat- oder Hydroxyalkylmethacrylateinheiten enthaltendes Polymerisat, ein Epoxyharz, Celluloseether, Celluloseester oder Polyester mit freien Hydroxylgruppen oder ein Polyamin, Polyamid oder Polyurethan ist.

7. Lichtempfindliches Gemisch nach Anspruch 1, dadurch gekennzeichnet, daß die lichtempfindliche Verbindung ein Photoinitiator für die Polymerisation bzw. Vernetzung der olefinisch ungesättigten Gruppen ist.

8. Lichtempfindliches Gemisch nach Anspruch 1, dadurch gekennzeichnet, daß die lichtempfindliche Verbindung eine bei Belichtung vernetzende Verbindung ist.

9. Lichtempfindliches Gemisch nach Anspruch 8, dadurch gekennzeichnet, daß die bei Belichtung vernetzende Verbindung ein Diazoniumsalz, ein p-Chinondiazid oder eine organische Azidoverbindung ist.

10. Lichtempfindliches Gemisch nach Anspruch 7 oder 8, dadurch gekennzeichnet, daß es ferner eine niedermolekulare polymerisierbare Verbindung mit mindestens einer olefinischen Doppelbindung enthält.

11. Lichtempfindliches Gemisch nach Anspruch 1 oder 10, dadurch gekennzeichnet, daß es ferner einen bei Raumtemperatur inaktiven, bei erhöhter Temperatur aktiven Polymerisationsinitiator enthält.

12. Lichtempfindliches Aufzeichnungsmaterial mit einem Schichtträger und einer lichtempfindlichen Schicht, dadurch gekennzeichnet, daß die lichtempfindliche Schicht aus einem Gemisch gemäß einem der Ansprüche 1 bis 11 besteht.

## Revendications

1. Composition photosensible, contenant en tant que composants essentiels un composé polymère comportant des radicaux latéraux à insaturation oléfinique, et un composé photosensible, caractérisée en ce que le composé polymère est un produit de réaction d'un composé à insaturation oléfinique, de formule générale I

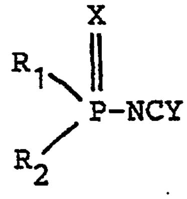

(I)

dans laquelle

X et Y sont identiques ou différents, et représentent un atome d'oxygène ou de soufre,
R1 est un radical aliphatique à insaturation oléfinique, ayant de 2 à 8 atomes de carbone, et
R2 est un radical aliphatique saturé ayant de 1 à 8 atomes de carbone, ou un radical aryle ayant de 6 à 10 atomes de carbone,
avec un polymère contenant de l'hydrogène actif.

2. Composition photosensible selon la revendication 1, caractérisée en ce que $R_1$ est un radical aliphatique à insaturation oléfinique ayant de 2 à 4 atomes de carbone.

3. Composition photosensible selon la revendication 1 ou 2, caractérisée en ce que $R_2$ est un radical aliphatique saturé ayant 1 ou 2 atomes de carbone, ou un radical phényle éventuellement substitué.

4. Composition photosensible selon l'une des revendications 1 à 3, caractérisée en ce que $R_1$ est le groupe vinyle et X et Y sont des atomes d'oxygène.

5. Composition photosensible selon la revendication 1, caractérisée en ce que le polymère contenant de l'hydrogène actif est un polymère contenant des groupes hydroxy ou amino.

6. Composition photosensible selon la revendication 5, caractérisée en ce que le polymère contenant des groupes hydroxy ou amino est un polymère contenant des motifs alcool vinylique, alcool allylique, acrylate d'hydroxyalkyle ou méthacrylate d'hydroxyalkyle, une résine époxy, un éther de cellulose, un ester de cellulose ou un polyester comportant des groupes hydroxy libres, ou une polyamine, un polyamide ou un polyuréthanne.

7. Composition photosensible selon la revendication 1, caractérisée en ce que le composé photosensible est un photoinitiateur pour la polymérisation ou la réticulation des groupes à insaturation oléfinique.

8. Composition photosensible selon la revendication 1, caractérisée en ce que le composé photosensible est un composé se réticulant à l'insolation.

9. Composition photosensible selon la revendication 8, caractérisée en ce que le composé se réticulant à l'exposition est un sel de diazonium, un p-quinonediazide ou un composé azido organique.

10. Composition photosensible selon la revendication 7 ou 8, caractérisée en ce qu'elle contient en outre un composé polymérisable à faible masse moléculaire, comportant au moins une double liaison oléfinique.

11. Composition photosensible selon la revendication 1 ou 10, caractérisée en ce qu'elle contient en outre un initiateur de polymérisation inactif à la température ambiante, actif à température élevée.

12. Matériau de reprographie photosensible, comportant un support de couche et une couche photosensible, caractérisé en ce que la couche photosensible est constituée d'une composition selon l'une des revendications 1 à 11.

**Claims**

1. A photosensitive mixture which contains a polymeric compound with lateral olefinically unsaturated radicals and a photosensitive compound as essential constituents, wherein the polymeric compound is a reaction product of an olefinically unsaturated compound of the general formula I

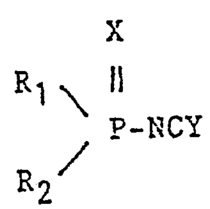

(I)

wherein
X and Y are the same or different and denote oxygen or sulfur,
R1 is an olefinically unsaturated aliphatic radical containing 2 to 8 carbon atoms and
R2 is a saturated aliphatic radical containing 1 to 8 carbon atoms or an aryl radical containing 6 to 10 carbon atoms,
with a polymer containing active hydrogen.

2. A photosensitive mixture as claimed in claim 1, wherein $R_1$ is an olefinically unsaturated aliphatic radical containing 2 to 4 carbon atoms.

3. A photosensitive mixture as claimed in claim 1 or 2, wherein $R_2$ is a saturated aliphatic radical containing 1 to 2 carbon atoms or an optionally substituted phenyl radical.

4. A photosensitive mixture as claimed in any of claims 1 to 3, wherein $R_1$ is a vinyl group and X and Y are oxygen atoms.

5. A photosensitive mixture as claimed in claim 1, wherein the polymer containing active hydrogen is a polymer containing hydroxyl or amino groups.

6. A photosensitive mixture as claimed in claim 5, wherein the polymer containing hydroxyl or amino groups is a polymer containing vinyl-alcohol, allyl-alcohol, hydroxyalkyl-acrylate or hydroxyalkyl-methacrylate units, an epoxy resin, cellulose ether, cellulose ester or polyester containing free hydroxyl groups or a polyamine, polyamide or polyurethane.

7. A photosensitive mixture as claimed in claim 1, wherein the photosensitive compound is a photoinitiator for the polymerization or crosslinking of the olefinically unsaturated groups.

8. A photosensitive mixture as claimed in claim 1, wherein the photosensitive compound is a compound which cross-links on exposure.

9. A photosensitive mixture as claimed in claim 8, wherein the compound which crosslinks on exposure is a diazonium salt, a p-quinone diazide or an organic azido compound.

10. A photosensitive mixture as claimed in claim 7 or 8 which further contains a low-molecular polymerizable compound containing at least one olefinic doublebond.

11. A photosensitive mixture as claimed in claim 1 or 10, which further contains a polymerization initiator which is inactive at room temperature and active at elevated temperature.

12. A photosensitive recording material comprising a layer support and a photosensitive layer, wherein the photosensitive layer is formed of a mixture as claimed in any of claims 1 to 11.